# EUROPÄISCHE PATENTANMELDUNG

(11) **EP 0 614 996 A1**
(43) Veröffentlichungstag der Anmeldung: **14.09.1994**
(21) Anmeldenummer: 94100754.4
(22) Anmeldetag: 20.01.1994
(51) Int. Cl.: C23C 14/16

(54) **Korrosionsschutzüberzug**

(30) Priorität: 11.03.1993 DE 4307668
(71) Anmelder: DORNIER LUFTFAHRT GmbH, D-88039 Friedrichshafen (DE)
(72) Erfinder: Holbein, Reinhold, Dr., D-88677 Markdorf (DE); Arnolds-Mayer, Gabriele, Dr., D-88662 Überlingen (DE)
(74) Vertreter: Frick, Gerhard, Dipl.-Ing.

(57) **Zusammenfassung**

Die Erfindung betrifft einen Korrosions-Schutzüberzug für Stahl, Titan, Titanlegierungen und Kupferlegierungswerkstoffe, der eine Schicht aus einer AlLiMg-Legierung umfaßt.

## Beschreibung

Die Erfindung betrifft einen Korrosionsschutzüberzug für Stahl, Titan, Titanlegierungen und Kupferlegierungswerkstoffe.

Als Korrosionsschutz werden im Flugzeugbau Cadmiumbeschichtungen eingesetzt. Cadmiumschichten sind jedoch nicht ausreichend meerwasserbeständig, wodurch es vor allem bei Flugbetrieb in maritimen Klimaten zu ihrer Auflösung und damit zu Korrosionsschäden kommt. Außerdem ist Cadmium ökologisch höchst bedenklich und sein Einsatz muß in zunehmendem Maße reduziert werden.

Der Erfindung liegt deshalb die Aufgabe zugrunde, einen Schutzüberzug für Flugzeugbauteile zu schaffen, der auch in maritimen Klimaten einen ausreichenden Korrosionsschutz bietet.

Diese Aufgabe wird mit einem Schutzübetrug nach Anspruch 1 gelöst. Vorteilhatte Ausgestaltungen der Erfindung sind Gegenstand weiterer Ansprüche.

Erfindungsgemäß umfaßt der Schutzüberzug eine Schicht aus Aluminium mit Beimischungen der unedlen Metalle Lithium und Magnesium, wobei der Li-Anteil bis zu ca. 3 Gew.% und der Mg-Anteil bis zu ca. 7 Gew.% beträgt.

Die Schichtdicken liegen in bevorzugten Ausführungsformen im Bereich von bis zu 10 µm.

Der Schutzüberzug ist geeignet für rostende und nichtrostende Stähle, Titan, Titanlegierungen und Kupferlegierungswerkstoffe.

Bei Verschleißbeanspruchung kann auf die erfindungsgemäße Korrosionsschutzschicht eine zusätzliche Schicht aus einer AlN-Legierung oder anderen Hartstoffreaktionsschichten aufgebracht werden. Damit kann die Reibcharakteristik (Reibkorrosion, Reibwertkonstanz und Reibwerthöhe, Gleit- und Adhäsionsverschleiß) bei tribologischer Beanspruchung verbessert werden. Die Dicke der tribologischen Schutzschicht liegt bevorzugt bei 3 bis 7 µm.

Die Erfindung eignet sich insbesondere zum Schutz von Bauteilen für Luftfahrtanwendungen. Sie eignet sich aber auch ganz allgemein zum Schutz von korrosionsanfälligen Bauteilen aus den genannten Werkstoffen, die bisher mit sowohl in der Herstellung als auch während der Nutzung umweltbelastenden Schutzschichten versehen werden.

Die Schichten haben folgende Funktionen und Eigenschaften:
- AlLiMg aufgetragen auf niedriglegierte, hochfeste Stähle bieten kathodischen Schutz des Grundwerkstoffes in chloridfreien und chloridhaltigen Medien vor Korrosion;
- AlLiMg aufgetragen auf korrosionsbeständige Stähle, Titan- und Kupferlegierungswerkstoffe schützen bei der in der Luftfahrt üblichen Mischbauweise unedlere Gegenwerkstoffe vor Kontaktkorrosion;
- bei zusätzlicher Beschichtung mit AlN oder anderen Hartstoffbeschichtungen wird die Reibcharakteristik bei tribologischer Beanspruchung verbessert;
- die Schichten sind elektrisch leitend und deshalb unproblematisch bei erforderlichen Masseanschlüssen;
- die Schichten bewirken verfahrensbedingt keine Versprödung des Grundwerkstoffs, der bei elektrochemisch aufgetragenen Schichten häufig beobachtet wird.

Die erfindungsgemäßen Schichten bzw. Schichtsysteme (Korrosionsschutzschicht und tribologische Schutzschicht) werden durch PVD-Beschichtungsverfahren (PVD = Physical Vapour Deposition), insbesondere durch das Arc-Verfahren aufgebracht. Dabei wird der Beschichtungswerkstoff unter Vakuum durch einen Lichtbogenverdampfer im Bereich des angreifenden Kathodenspots (Durchmesser einige µm) explosionsartig verdampft und hochgradig ionisiert. Durch elektrische Wechselwirkungen und eine zusätzlich angelegte Biasspannung werden die Ionen auf relativ hohe Energien (100 eV - Bereich) gebracht. Dadurch werden beim Auftreffen auf das Target durch Entfernen von Oxidschichten und Aktivieren der Oberflächen im allgemeinen hohe Haftfestigkeit und Dichten erreicht, sofern die für das Arc-Verfahren charakteristischen Droplets vermieden werden.

Die die Erfindung betreffenden Schichten bzw. Schichtsysteme können auch mittels anderer bekannter PVD-Beschichtungsverfahren wie Bedampfen, Sputterdeposition, Ion Beam Assisted Deposition (IBAD) aufgebracht werden, sofern folgendes gewährleistet ist:
- ausreichende Haftfestigkeit;
- ausreichende Dichtigkeit;
- ausreichende Schichtdickenkonstanz;
- eine homogene Atomverteilung der Legierungspartner über die gesamte Schichtdicke;
- keine Beeinträchtigung des Grundwerkstoffs infolge zu hoher Temperaturbeaufschlagung.

## Patentansprüche

1. Korrosions-Schutzüberzug für Stahl, Titan, Titanlegierungen und Kupferlegierungswerkstoffe, **dadurch gekennzeichnet**, daß er eine Schicht aus einer AlLiMg-Legierung umfaßt.

2. Korrosions-Schutzüberzug nach Anspruch 1, **dadurch gekennzeichnet**, daß die AlLiMg-Legierung bis zu 3 Gew.% Li und bis zu 7 Gew.% Mg enthält.

3. Korrosions-Schutzüberzug nach einem der vorangehenden Ansprüche, **dadurch gekennzeichnet**, daß zusätzlich eine Schicht aus einer AlN-Legierung oder einer anderen Hartstoffbeschichtung zur Verbesserung der Reibcharakteristik bei tribologischer Beanspruchung vorhanden ist.
